(19) **Europäisches Patentamt / European Patent Office / Office européen des brevets**

(11) **EP 1 972 931 B1**

(12) **EUROPEAN PATENT SPECIFICATION**

(45) Date of publication and mention of the grant of the patent:
**25.01.2012 Bulletin 2012/04**

(51) Int Cl.:
***G01R 33/07*** *(2006.01)*

(21) Application number: **06810460.3**

(22) Date of filing: **22.09.2006**

(86) International application number:
**PCT/JP2006/318847**

(87) International publication number:
**WO 2007/077653 (12.07.2007 Gazette 2007/28)**

(54) **METHOD OF MEASURING CRITICAL ELECTRIC CURRENT VALUE OF SUPERCONDUCTING WIRE**

VERFAHREN ZUR MESSUNG DES KRITISCHEN ELEKTRISCHEN STROMWERTS VON SUPERLEITENDEM DRAHT

PROCEDE DE MESURE DE LA VALEUR CRITIQUE DE COURANT ELECTRIQUE D'UN FIL SUPRACONDUCTEUR

(84) Designated Contracting States:
**CH DE DK FR GB IT LI**

(30) Priority: **28.12.2005 JP 2005378825**

(43) Date of publication of application:
**24.09.2008 Bulletin 2008/39**

(73) Proprietor: **Sumitomo Electric Industries, Ltd.
Osaka-shi, Osaka 541-0041 (JP)**

(72) Inventors:
- **UENO, Eisaku, c/o Osaka Works of Sumitomo Konohana-ku 554-0024 OSAKA-SHI, OSAKA (JP)**
- **KATO, Takeshi c/o Osaka Works of Sumitomo Konohana-ku 554-0024 OSAKA-SHI, OSAKA (JP)**
- **FUJIKAMI, Jun c/o Osaka Works of Sumitomo Konohana-ku 554-0024 OSAKA-SHI, OSAKA (JP)**

(74) Representative: **Kreutzer, Ulrich et al
Cabinet Beau de Loménie
Bavariaring 26
80336 München (DE)**

(56) References cited:
**EP-B1- 0 860 705      JP-A- 10 197 468
JP-A- 10 239 260      JP-A- 63 085 370
JP-A- 2002 108 068    JP-A- 2003 194 867
JP-A- 2004 347 610    US-A- 5 936 394**

- **GOODRICH L F: "HIGH TC SUPERCONDUCTOR VOLTAGE-CURRENT SIMULATOR AND THE PULSE METHOD OF MEASURING CRITICAL CURRENT*" CRYOGENICS, ELSEVIER, KIDLINGTON, GB LNKD- DOI:10.1016/0011-2275 (91)90234-N, vol. 31, no. 8, 1 August 1991 (1991-08-01), pages 720-727, XP000258981 ISSN: 0011-2275**

**Description**

TECHNICAL FIELD

The present invention relates to a method of measuring the critical current value of a superconducting wire, and more specifically, it relates to a method of measuring the critical current value of a long superconducting wire exceeding 100 m in length.

BACKGROUND ART

In order to evaluate the critical current characteristic of a high-temperature superconducting wire, a method and an apparatus disclosed in the following Japanese Patent Laying-Open No. 10-239260 (Patent Document 1) are employed, for example.

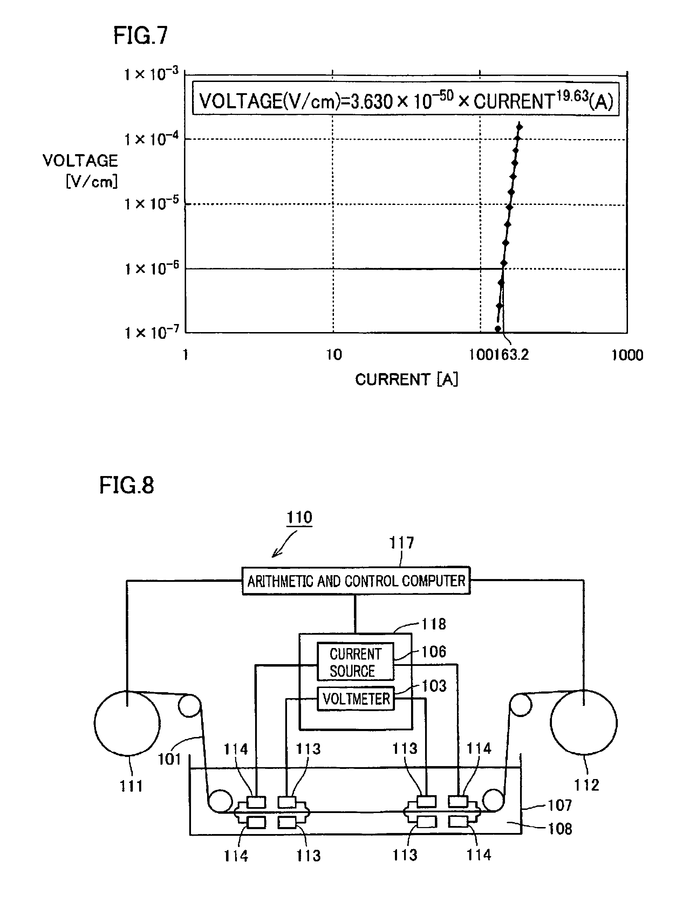

Fig. 8 is a model diagram showing an apparatus for measuring the critical current characteristic of a superconducting wire disclosed in Japanese Patent Laying-Open No. 10-239260. Referring to Fig. 8, a measuring apparatus 110 mainly comprises a cooling bath 107, a feed roller 131, a backing roller 112, electrodes 113 and 114, an arithmetic and control computer 117 and a measurer 118.

A long superconducting wire 101 wound on feed roller 111 is taken up by backing roller 112. Between feed roller 111 and backing roller 112, superconducting wire 101 is dipped in liquid nitrogen 108 contained in cooling bath 107. Thus, a partial section of superconducting wire 101 is cooled with the liquid nitrogen and brought into a superconducting state. The respective ones of electrodes 114 electrically connected to a current source 106 are pressed against the surface of superconducting wire 101, thereby feeding a current to the aforementioned section of superconducting wire 101. In this electrification state, the respective ones of electrodes 113 electrically connected to a voltmeter 103 are pressed against the surface of superconducting wire 101, for measuring the voltage with voltmeter 103. The current flowing through superconducting wire 101 and the voltage generated in the aforementioned section of superconducting wire 101 are measured while gradually increasing the current fed to superconducting wire 101. Thus, a large number of sets of current values and voltage values are obtained. Then, a voltage exceeding a prescribed voltage value (critical voltage value) and most approximating the prescribed voltage value is retrieved from among the large number of sets of current values and voltage values, and a current value corresponding this voltage value is regarded as the critical current value of superconducting wire 101 in the aforementioned section.

Thereafter feed roller 111 and backing roller 112 are so rotated as to move superconducting wire 101, so that currents and voltages are measured in another section of superconducting wire 101 similarly to the above, for obtaining the critical current value. The critical current value of the overall superconducting wire 101 is obtained through the voltage values of a plurality of sections measured in this manner.

Patent Document I : Japanese Patent Laying-Open No. 10-239260

DISCLOSURE OF THE INVENTION

PROBLEMS TO BE SOLVED BY THE INVENTION

If the current flowing through superconducting wire 101 is increased, however, induced electromotive force results from the inductance of superconducting wire 101. In the method described in Patent Document 1, therefore, there has been such a problem that the current flowing through superconducting wire 101 is rendered so instable that no correct critical current value can be obtained.

Accordingly, an object of the present invention is to provide a method of measuring the critical current value of a superconducting wire capable of measuring a correct critical current value.

MEANS FOR SOLVING THE PROBLEMS

A method of measuring the critical current value of a superconducting wire according to a first aspect of the present invention comprises the step of measuring first to $m^{th}$ (m denotes an integer of at least 2) current values ($I_1$, $I_2$, ..., $I_m$) and first to $m^{th}$ voltage values ($V_1$, $V_2$, ..., $V_m$) corresponding to the respective ones of the first to $m^{th}$ current values by feeding a current to a superconducting wire and varying the value of the current. The first current value and the first voltage value are measured by retaining the current fed from a constant current source to the superconducting wire in a state set to a first set value for a constant time and thereafter measuring the current flowing through the superconducting wire and a voltage generated in the superconducting wire. The $k^{th}$ (k denotes an integer satisfying $2 \le k \le m$) current value and the $k^{th}$ voltage value are measured by retaining the current fed from the constant current source to the superconducting wire in a state set to a $k^{th}$ set value higher than a $(k - 1)^{th}$ set value for the constant time and thereafter measuring the current flowing through the superconducting wire and the voltage generated in the superconducting wire.

A method of measuring the critical current value of a superconducting wire according to a second aspect of the present invention comprises the steps of dividing the total length of a superconducting wire into $\underline{n}$ lengths from a first section to an $n^{th}$ section and measuring first to $m^{th}$ (m denotes an integer of at least 2) current values ($I_1, I_2, ..., I_m$) and first to $m^{th}$ voltage values ($V_{1,1}$ to $V_{1,m}$, $V_{2,1}$ to $V_{2,m}$, $\cdots$, $V_{n,1}$ to $V_{n,m}$; where $V_{k,j}$ denotes a voltage value corresponding to an $i^{th}$ current value in a $k^{th}$ section (k denotes an integer of 1 to n, i denotes an integer of 1 to m)) corresponding to the respective ones of the first to $m^{th}$ current values by feeding a current to the respective sections from the first section to the $n^{th}$ section and varying the value of the current. The first current value ($I_1$) and the first voltage value ($V_{1,1}, V_{2,1}, \cdots, V_{n,1}$) in each of the first section to the $n^{th}$ section are measured by retaining the current fed from a constant current source to the superconducting wire in a state set to a first set value for a constant time and thereafter measuring the current flowing through the superconducting wire and a voltage generated in the superconducting wire. The $j^{th}$ (j denotes an integer satisfying $2 \leq j \leq m$) current value ($I_j$) and the $j^{th}$ voltage value ($V_{1,j} V_{2,j}, \cdots, V_{n,j}$) in each of the first section to the $n^{th}$ section are measured by retaining the current fed from the constant current source to the superconducting wire in a state set to a $j^{th}$ set value higher than a $(j - 1)^{th}$ set value for the constant time and thereafter measuring the current flowing through the superconducting wire and the voltage generated in the superconducting wire.

According to the method of measuring the critical current value of a superconducting wire according to each of the first and second aspects of the present invention, induced electromotive force resulting from the inductance of the superconducting wire can be reduced by retaining the current fed from the constant current source to the superconducting wire in the state set to the first set value for the constant time. Thus, the current value can be measured after the current flowing through the superconducting wire is stabilized, so that a correct critical current value can be obtained.

According to the method of measuring the critical current value of a superconducting wire according to the second aspect of the present invention, in addition, the critical current value along the total length or in a specific section can be measured as to a long superconducting wire exceeding 100 m in length, for example.

The method of measuring the critical current value of a superconducting wire according to the first aspect of the present invention preferably further comprises the steps of calculating a straight line showing the relation between the current flowing through the superconducting wire and the voltage generated in the superconducting wire on the basis of the first to $m^{th}$ current values ($I_1, I_2, \cdots, I_m$) and the first to $m^{th}$ voltage values ($V_1, V_2, \cdots, V_m$) and calculating the critical current value of the superconducting wire with the straight line.

Thus, when the first to $m^{th}$ current values ($I_1, I_2, \cdots, I_m$) and the first to $m^{th}$ voltage values ($V_1, V_2, \cdots, V_m$) are obtained, the critical current value can be calculated on the basis o the straight line obtained from these values. Therefore, the critical current value can be calculated without actually measuring the current value serving as the critical current value and the voltage value corresponding thereto, whereby the critical current value can be easily measured and the measurement can be speeded up,

The method of measuring the critical current value of a superconducting wire according to the first aspect of the present invention preferably calculates the straight line with the least-squares method in the step of calculating the straight line.

Thus, the precision of the calculated straight line is improved even if the measured current values and voltage values include errors, so that measurement errors caused in the critical current value can be minimized.

The method of measuring the critical current value of a superconducting wire according to the second aspect of the present invention preferably further comprises the steps of calculating the sum ($V_{sum(1)} = V_{x,1} + V_{x,+1,1} + ... + V_{y,1}$) of the first voltage values measured in the respective sections from the $x^{th}$ section to the $y^{th}$ section (x and y denote integers, and $1 \leq x \leq y \leq n$ to the sum ($V_{sum(m)} = V_{x,m} + V_{x,+1,m} + \cdots + V_{y,m}$) of the $m^{th}$ voltage values, calculating a straight line showing the relation between the current flowing through the superconducting wire and the voltage generated in the superconducting wire on the basis of the first to $m^{th}$ current values ($I_1, I_2, \cdots, I_n$) and the sum ($V_{sum(1)} = V_{x,1} + V_{x,+1,1} + \cdots + V_{y,1}$) of the first voltage values to the sum ($V_{sum(m)} = V_{x,m} + V_{x,-1,m} + \cdots + V_{y,m}$) of the $m^{th}$ voltage values and calculating the critical current value of the superconducting wire with the straight line.

Thus, when the first to $m^{th}$ current values ($I_1, I_2, \cdots, I_m$) and the first to $m^{th}$ voltage values ($V_1, V_2, \cdots, V_m$) are obtained in a section (from the $x^{th}$ section to the $y^{th}$ section) for measuring the critical current value, the critical current value of the section can be calculated on the basis of the straight line obtained from these values. Therefore, the critical current value can be calculated without actually measuring the current value serving as the critical current value and the voltage value corresponding thereto, whereby the critical current value can be easily measured and the measurement can be speeded up.

The method of measuring the critical current value of a superconducting wire according to the second aspect preferably calculates the straight line with the least-squares method in the step of calculating the straight line.

Thus, the precision of the calculated straight line is improved even if the measured current values and voltage values include errors, so that measurement errors caused in the critical current value can be minimized.

EFFECTS OF THE INVENTION

According to the method of measuring the critical current value of a superconducting wire according to the present invention, a correct critical current value can be measured.

BRIEF DESCRIPTION OF THE DRAWINGS

Fig. 1 is a model diagram showing a measuring apparatus for the critical current value of a superconducting wire according to a first embodiment of the present invention.
Fig. 2 is a model diagram showing a portion enclosed with II in Fig. 1 in an enlarged manner.
Fig. 3 is a diagram showing a state where a superconducting wire and electrodes are in contact with each other in Fig. 2.
Fig. 4A is a diagram schematically showing a method of controlling a set value of a constant current source in the first embodiment of the present invention.
Fig. 4B is a diagram schematically showing time changes in a current flowing through the superconducting wire and a voltage in the first embodiment of the present invention.
Fig. 4C is a diagram schematically showing other exemplary time changes in the current flowing through the superconducting wire and the voltage in the first embodiment of the present invention.
Fig. 4D is a diagram schematically showing further exemplary time changes in the current flowing through the superconducting wire and the voltage in the first embodiment of the present invention.
Fig. 5 is a diagram showing the relation between current values and voltage values in Table 1 to 3.
Fig 6(a) is a diagram showing a time change in the set value of the constant current source in a case of increasing the set value of the constant current source in proportion to time, and Fig. 6(b) is a diagram showing a time change in the voltage generated in the superconducting wire in the case of increasing the set value of the constant current source in proportion to time.
Fig. 7 is a diagram showing the relation between current values and voltage values in Table 4.
Fig. 8 is a model diagram showing an apparatus for measuring the critical current characteristic of a superconducting wire disclosed in Japanese Patent Laying-Open No. 10-239260.

DESCRIPTION OF THE REFERENCE SIGNS

1, 101 superconducting wire, 3, 4, 103 voltmeter, 5 shunt resistor, 6 constant current source, 7, 107 cooling bath, 8, 108 liquid nitrogen, 10, 110 measuring apparatus, 11, 111 feed roller, 12, 112 backing roller, 13a, 13c upper voltage electrode, 13b, 13d lower voltage electrode, 14a, 14c upper current electrode, 14b, 14d lower current electrode, 15 auxiliary roller, 17, 117 arithmetic and control computer, 18, 118 measurer, 30 electrode portion, 31 electrode drive portion, 32 electrode support portion, 100 measurement section, 106 current source, 113, 114 electrode.

BEST MODES FOR CARRYING OUT THE INVENTION

Embodiments of the present invention are now described with reference to the drawings.

(First Embodiment)

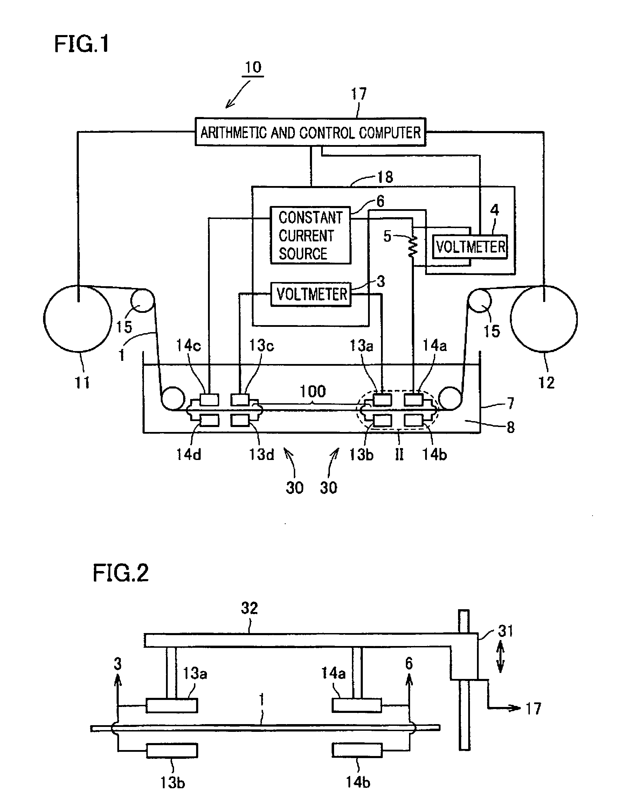

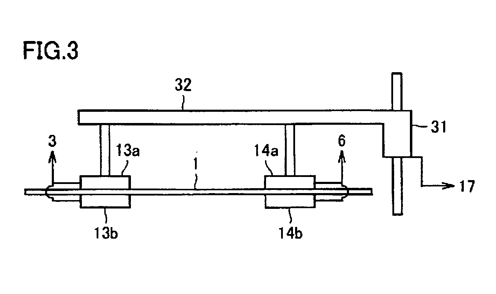

Fig. 1 is a model diagram showing a measuring apparatus for the critical current value of a superconducting wire according to a first embodiment of the present invention. Fig. 2 is a model diagram showing a portion enclosed with II in Fig. 1 in an enlarged manner. Fig. 3 is a diagram showing a state where a superconducting wire and electrodes are in contact with each other. Referring to Figs. 1 to 3, a measuring apparatus 10 comprises a feed roller 11, a backing roller 12, an arithmetic and control computer 17, an electrode portion 30, a cooling bath 7 and a measurer 18.

Feed roller 11 and backing roller 12 constitute feed means. Feed roller 11 and backing roller 12 are cylindrical. A superconducting wire 1 is wound on feed roller 11 and backing roller 12. Before measurement is started, superconducting wire 1 is wound only on feed roller 11, while an end of superconducting wire 1 is simply fixed to backing roller 12. Superconducting wire 1 is composed of an oxide superconducting material stored in a silver sheath. While the material for this oxide superconducting material is not particularly restricted, $(Bi_{2-x}-Pb_X)Sr_2Ca_2Cu_3O_{10}$ can be employed, for example. The length of superconducting wire 1, preferably at least 100 m, may be less than 100 m. The shape of superconducting wire 1, not particularly restricted, is preferably tapelike, while the width and the thickness thereof may be about 3 mm and about 0.2 mm respectively. When the measurement is started, superconducting wire 1 is successively taken up from feed roller 11 on backing roller 12. Feed roller 11, backing roller 12 and an auxiliary roller 15 are all rotatable. Arithmetic and control computer 17 is connected to feed roller 11, backing roller 12 and measurer 18. Arithmetic and control computer 17 supplies signals to feed roller 11 and backing roller 12, for rotating feed roller 11 and backing roller 12. At this time, arithmetic and control computer 17 is capable of rotating only feed roller 11, while arithmetic and control computer 17 is also capable of rotating only backing roller 12. Therefore, arithmetic and control computer 17 can properly adjust tension applied to superconducting wire 1 by supplying the signals to feed roller 11 and backing roller 12. Further, arithmetic and control computer 17 is so connected with measurer 18 that the same can perform various operations from data obtained in measurer 18.

Electrode portion 30 comprises upper current electrodes 14a and 14c, lower current electrodes 14b and 14d, upper voltage electrodes 13a and 13c, lower voltage electrodes 13b and 13d, an electrode support portion 32 and an electrode drive portion 31. Each of these electrodes 14a to 14d and 13a to 13d is composed of silver or a silver alloy, has sides of 3 cm in length, and is substantially in the form of a rectangular parallelepiped. Lower current electrodes 14b and 14d and lower voltage electrodes 13 band 13d are fixed to cooling bath 7, and electrically insulated from cooling bath 7. Upper current electrodes 14a and 14c and upper voltage electrodes 13a and 13c are all fixed to electrode support portion 32. Electrode support portion 32 is vertically movable in Fig. 2 through electrode drive portion 31. When electrode drive portion 31 moves downward, therefore, upper current electrodes 14a an 14c and upper voltage electrodes 13a and 13c come into contact with superconducting wire 1, and further press superconducting wire 1 downward. Thus, upper current electrodes 14a and 14c and lower current electrodes 14b and 14d hold superconducting wire 1 therebetween, as shown in Fig. 3. Further, upper voltage electrodes 13a and 13c and lower voltage electrodes 13b and 13d hold superconducting wire 1 therebetween.

Cooling bath 7 is filled with liquid nitrogen 8 or the like, for example. Liquid nitrogen 8 is employed for cooling superconducting wire 1.

Measurer 18 includes a constant current source 6 and voltmeters 3 and 4. Constant current source 6 has a first electrode connected to upper current electrode 14a and lower current electrode 14b through a shunt resistor 5 and a second electrode connected to upper current electrode 14c and lower current electrode 14d. Thus, constant current source 6 can feed a current of a constant value to superconducting wire 1. Voltmeter 3 has a first electrode connected to upper voltage electrode 13a and lower voltage electrode 13b and a second electrode connected to upper voltage electrode 13c and lower voltage electrode 13d. Thus, voltmeter 3 can measure the potential difference between upper voltage electrode 13a and lower voltage electrode 13b and between upper voltage electrode 13c and lower voltage electrode 13d, i.e., the potential difference in a measurement section 100. Voltmeter 4, connected to both ends of shunt resistor 5, can measure the potential difference between both ends of shunt resistor 5. Data obtained in constant current source 6 and voltmeters 3 and 4 are transferred to arithmetic and control computer 17.

A method of measuring the critical current value of a superconducting wire according to this embodiment is now described.

First, superconducting wire 1 of a constant length is prepared, and this superconducting wire 1 is arranged as shown in Fig. 1. If the distance of measurement section 100 is 4 m with respect to superconducting wire 1 of 100 m, superconducting wire 1 is partitioned into lengths of 4 m from the first end up to the second end of superconducting wire 1 on the assumption that a portion of 4 m from the first end of superconducting wire 1 forms a first section, so that superconducting wire 1 is divided into 25 lengths from the first section to a 25th section. Arithmetic and control computer 17 feeds signals to feed roller 11 and backing roller 12 so that the first section (portion up to 4 m from the first end of superconducting wire 1) is located on the portion of measurement section 100.

Then, arithmetic and control computer 17 feeds a signal to electrode drive portion 31 for moving electrode support portion 32 downward. Electrode drive portion 31 receiving this signal lowers electrode support portion 32. Thus, superconducting wire 1 is held between upper voltage electrode 13a and lower voltage electrode 13b, as shown in Fig. 3. Further, superconducting wire 1 is held between upper current electrode 14a and lower current electrode 14b. Also on an electrode portion located on the left side in Fig. 1, superconducting wire 1 is held between upper voltage electrode 13c and lower voltage electrode 13d, and held between upper current electrode 14c and lower current electrode 14d.

In this state, constant current source 6 feeds a prescribed current to superconducting wire 1. Voltmeter 3 measures the current potential difference between upper voltage electrode 13a and lower voltage electrode 13b and between upper voltage electrode 13c and lower voltage electrode 13d, i.e., the potential difference in measurement section 100, for obtaining the voltage value of measurement section 100. Further, the potential difference between both ends of shunt resistor 5 is measured with the value of voltmeter 4. The current flowing through the shunt resistor is calculated on the basis of this potential difference and the resistance value of the shunt resistor, and this current value is regarded as the value of the current flowing through superconducting wire 1. The current value in measurement section 100 of superconducting wire 1 as well as the voltage value in measurement section 100 of superconducting wire 1 are measured while the set value of the current in constant current source 6 is increased. Thus, $m$ ($m$ denotes an integer of at least 2) sets of current values and voltage values are obtained.

The aforementioned current values and voltage values in this embodiment are measured after retaining the current fed from constant current source 6 to superconducting wire 1 in a state set to a prescribed set value for a constant time. This measuring method is now described in detail.

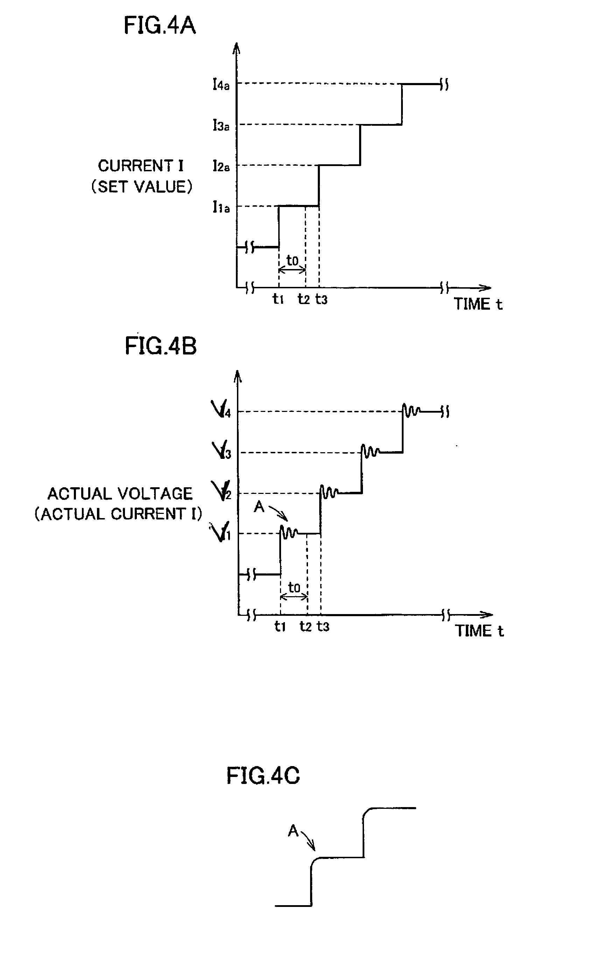

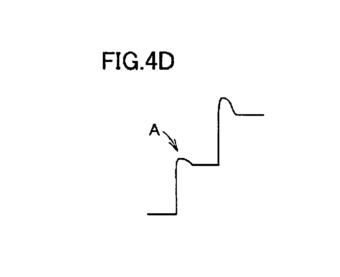

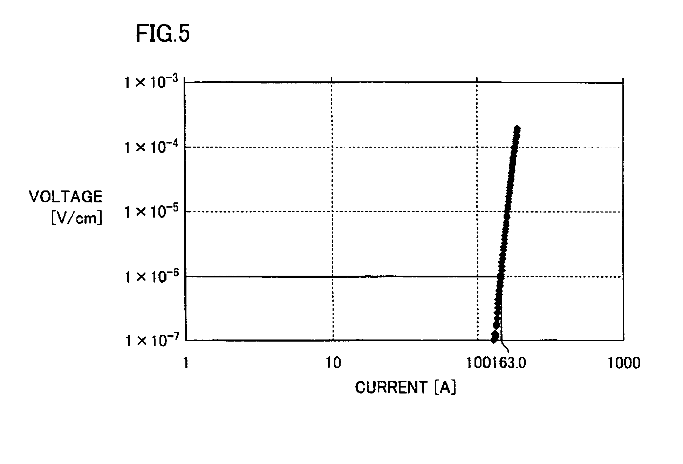

Fig. 4A is a diagram schematically showing a method of controlling the set value of the constant current source in the first embodiment of the present invention, and Fig. 4B is a diagram schematically showing time changes in the current flowing through the superconducting wire and the voltage in the first embodiment of the present invention. Fig. 4C is a diagram schematically showing other exemplary time changes in the current flowing through the superconducting wire and the voltage in the first embodiment of the present invention, and Fig. 4D is a diagram schematically showing further exemplary time changes in the current flowing through the superconducting wire and the voltage in the first embodiment of the present invention. Referring to Figs. 4A and 4B, the set value of the constant current source is set to a set value $I_{1a}$ at a time $t_1$. The current is retained in the state set to the set value $I_{1a}$ (first set value) for a time to (about 0.1 sec., for example), for measuring a current value $I_1$ (first current value) and a voltage value $V_1$ (first voltage value) at a time $t_2$ after a lapse of the time $t_0$. When the set value of the constant current source is set (increased) to $I_{1a}$ at the time $t_1$, induced electromotive force resulting from the inductance of superconducting wire 1 is generated in measurement section 100, and noise (arrow $\underline{A}$ in Fig. 4B) is caused in the value of the voltage actually generated in superconducting wire 1. The shape of the noise varies with the circuit structure of the power source, and may be observed as shown in Fig. 4C or 4D. This induced electromotive force is generated in a magnitude proportionate to the rate of time change in the current flowing through superconducting wire 1, and the noise is generally increased as the rate of rise of the current is increased. The magnitude of the induced electromotive force also depends on the length of the superconducting wire, and the noise is increased in measurement of a superconducting wire having a length in the meter range. However, this noise is reduced with time, and hence the actual current value and the current value reach a substantially constant value (current value substantially identical to the set value) at the time $t_2$ after a lapse of the time $t_0$. Thereafter the set value of the constant current source is discontinuously increased to a set value $I_{2a}$ (second set value) at a time $t_3$, and the current is retained in the state set to the set value $I_{2a}$ for the time $t_0$, for measuring a current value $I_2$ (second current value) and a voltage value $V_2$ (second voltage value). Current values $I_1$ to $I_m$ (first to $m^{th}$ current values) in the first section of the superconducting wire and voltage values $V_{1,1}$ to $V_{l,m}$ (first to $m^{th}$ voltage values) corresponding to the respective ones of the current values $I_1$ to $I_m$ are measured by this method. As exemplary measurement results, Tables 1 to 3 show exemplary sets of current values $I_1$ to $I_{115}$ and voltage values $V_1$ to $V_{115}$ measured in the first section of superconducting wire 1 in a case where the measurement frequency $\underline{m}$ is 115 times. Further, Fig. 5 shows the relation between the current values and the voltage values in Tables 1 to 3.

Table 1

| Measurement Number | Current Value $I_1$~$I_{115}$(A) | Voltage Value $V_{1,1}$~$V_{1,115}$ (V) | Voltage Value per cm (V/cm) |
|---|---|---|---|
| 1 | -0.2 | $-7.0 \times 10^{-5}$ | $-1.74 \times 10^{-10}$ |
| 2 | 4.6 | $7.4 \times 10^{-4}$ | $1.84 \times 10^{-9}$ |
| 3 | 9.5 | $2.0 \times 10^{-3}$ | $5.09 \times 10^{-9}$ |
| 4 | 14.4 | $2.6 \times 10^{-3}$ | $6.45 \times 10^{-9}$ |
| 5 | 19.3 | $9.4 \times 10^{-4}$ | $2.33 \times 10^{-9}$ |
| 6 | 24.2 | $-7.8 \times 10^{-4}$ | $-1.94 \times 10^{-9}$ |
| 7 | 29.1 | $3.0 \times 10^{-3}$ | $7.42 \times 10^{-9}$ |
| 8 | 34.0 | $-2.3 \times 10^{-3}$ | $-5.73 \times 10^{-9}$ |
| 9 | 38.9 | $2.2 \times 10^{-3}$ | $5.53 \times 10^{-9}$ |
| 10 | 43.8 | $-2.4 \times 10^{-3}$ | $-5.90 \times 10^{-9}$ |
| 11 | 48.7 | $-1.3 \times 10^{-3}$ | $-3.20 \times 10^{-9}$ |
| 12 | 53.6 | $-6.4 \times 10^{-5}$ | $-1.60 \times 10^{-10}$ |
| 13 | 58.5 | $1.0 \times 10^{-4}$ | $2.62 \times 10^{-10}$ |
| 14 | 63.4 | $-1.6 \times 10^{-4}$ | $-3.90 \times 10^{-10}$ |
| 15 | 68.3 | $2.1 \times 10^{-4}$ | $5.31 \times 10^{-10}$ |
| 16 | 73.1 | $1.5 \times 10^{-3}$ | $3.83 \times 10^{-9}$ |
| 17 | 78.0 | $-4.4 \times 10^{-4}$ | $-1.10 \times 10^{-9}$ |

(continued)

| Measurement Number | Current Value $I_1$~$I_{115}$(A) | Voltage Value $V_{1,1}$~$V_{1,115}$ (V) | Voltage Value per cm (V/cm) |
|---|---|---|---|
| 18 | 82.9 | $5.9 \times 10^4$ | $1.48 \times 10^{-9}$ |
| 19 | 87.8 | $8.6 \times 10^{-1}$ | $2.15 \times 10^{-9}$ |
| 20 | 92.7 | $8.4 \times 10^{-4}$ | $2.09 \times 10^{-9}$ |
| 21 | 97.6 | $1.6 \times 10^{-3}$ | $3.91 \times 10^{-9}$ |
| 22 | 102.5 | $3.5 \times 10^{-4}$ | $8.86 \times 10^{-10}$ |
| 23 | 103.5 | $1.1 \times 10^4$ | $2.79 \times 10^{-10}$ |
| 24 | 104.5 | $-7.3 \times 10^{-4}$ | $-1.82 \times 10^{-9}$ |
| 25 | 105.4 | $-8.1 \times 10^{-4}$ | $-2.03 \times 10^{-9}$ |
| 26 | 106.4 | $-4.0 \times 10^{-3}$ | $-9.95 \times 10^{-9}$ |
| 27 | 107.4 | $4.6 \times 10^{-4}$ | $1.15 \times 10^{-9}$ |
| 28 | 108.4 | $-1.1 \times 10^{-4}$ | $-2.71 \times 10^{-10}$ |
| 29 | 109.3 | $-3.3 \times 10^{-4}$ | $-8.32 \times 10^{-10}$ |
| 30 | 110.3 | $2.2 \times 10^{-4}$ | $5.46 \times 10^{-10}$ |
| 31 | 111.3 | $1.3 \times 10^{-3}$ | $3.24 \times 10^{-9}$ |
| 32 | 112.3 | $1.8 \times 10^{-3}$ | $4.38 \times 10^{-9}$ |
| 33 | 113.2 | $1.8 \times 10^{-3}$ | $4.61 \times 10^{-9}$ |
| 34 | 114.2 | $1.3 \times 10^{-3}$ | $3.16 \times 10^{-9}$ |
| 35 | 115.2 | $9.2 \times 10^{-4}$ | $2.31 \times 10^{-9}$ |
| 36 | 116.2 | $1.2 \times 10^{-3}$ | $3.05 \times 10^{-9}$ |
| 37 | 117.2 | $1.6 \times 10^{-3}$ | $4.08 \times 10^{-9}$ |
| 38 | 118.1 | $1.8 \times 10^{-3}$ | $4.59 \times 10^{-9}$ |
| 39 | 119.1 | $2.0 \times 10^{-3}$ | $5.06 \times 10^{-9}$ |
| 40 | 120.1 | $9.0 \times 10^{-4}$ | $2.24 \times 10^{-9}$ |

Table 2

| Measurement Number | Current Value $I_1$~$I_{115}$(A) | Voltage Value $V_{1,1}$~$V_{1,115}$(V) | Voltage Value per cm (V/cm) |
|---|---|---|---|
| 41 | 121.1 | $2.6 \times 10^{-3}$ | $6.52 \times 10^{-9}$ |
| 42 | 122.0 | $2.4 \times 10^{-3}$ | $5.89 \times 10^{-9}$ |
| 43 | 123.0 | $3.3 \times 10^{-3}$ | $8.13 \times 10^{-9}$ |
| 44 | 124.0 | $2.5 \times 10^{-3}$ | $6.15 \times 10^{-9}$ |
| 45 | 125.0 | $2.7 \times 10^{-3}$ | $6.66 \times 10^{-9}$ |
| 46 | 125.9 | $2.6 \times 10^{-3}$ | $6.41 \times 10^{-9}$ |
| 47 | 126.9 | $3.8 \times 10^{-3}$ | $9.47 \times 10^{-9}$ |
| 48 | 127.9 | $3.9 \times 10^{-3}$ | $9.70 \times 10^{-9}$ |
| 49 | 128.9 | $4.0 \times 10^{-3}$ | $1.01 \times 10^{-8}$ |
| 50 | 129.8 | $5.1 \times 10^{-3}$ | $1.29 \times 10^{-8}$ |
| 51 | 130.8 | $4.3 \times 10^{-3}$ | $1.07 \times 10^{-8}$ |
| 52 | 131.8 | $4.6 \times 10^{-3}$ | $1.15 \times 10^{-8}$ |

(continued)

| Measurement Number | Current Value $I_1$~$I_{115}$(A) | Voltage Value $V_{1,1}$~$V_{1,115}$(V) | Voltage Value per cm (V/cm) |
|---|---|---|---|
| 53 | 132.8 | $5.1 \times 10^{-3}$ | $1.28 \times 10^{8}$ |
| 54 | 133.8 | $6.6 \times 10^{-3}$ | $1.65 \times 10^{-8}$ |
| 55 | 134.7 | $7.3 \times 10^{-3}$ | $1.81 \times 10^{-8}$ |
| 56 | 135.7 | $8.8 \times 10^{-3}$ | $2.19 \times 10^{-8}$ |
| 57 | 136.7 | $1.1 \times 10^{-2}$ | $2.65 \times 10^{-8}$ |
| 58 | 137.7 | $1.3 \times 10^{-2}$ | $3.15 \times 10^{-8}$ |
| 59 | 138.6 | $1.5 \times 10^{-2}$ | $3.76 \times 10^{8}$ |
| 60 | 139.6 | $1.8 \times 10^{-2}$ | $4.38 \times 10^{-8}$ |
| 61 | 140.6 | $2.0 \times 10^{-2}$ | $5.07 \times 10^{-8}$ |
| 62 | 141.6 | $2.4 \times 10^{-2}$ | $5.94 \times 10^{-8}$ |
| 63 | 142.5 | $2.8 \times 10^{-2}$ | $7.03 \times 10^{8}$ |
| 64 | 143.5 | $3.2 \times 10^{-2}$ | $7.96 \times 10^{-8}$ |
| 65 | 144.5 | $3.6 \times 10^{-2}$ | $9.05 \times 10^{-8}$ |
| 66 | 145.5 | $4.3 \times 10^{-2}$ | $1.06 \times 10^{-7}$ |
| 67 | 146.4 | $4.9 \times 10^{-2}$ | $1.23 \times 10^{-7}$ |
| 68 | 147.4 | $5.7 \times 10^{-2}$ | $1.42 \times 10^{-7}$ |
| 69 | 148.4 | $6.6 \times 10^{-2}$ | $1.64 \times 10^{-7}$ |
| 70 | 149.4 | $7.6 \times 10^{-2}$ | $1.91 \times 10^{-7}$ |
| 71 | 150.3 | $8.7 \times 10^{-2}$ | $2.17 \times 10^{-7}$ |
| 72 | 151.3 | $1.0 \times 10^{-1}$ | $2.52 \times 10^{-7}$ |
| 73 | 152.3 | $1.1 \times 10^{-1}$ | $2.85 \times 10^{-7}$ |
| 74 | 153.2 | $1.3 \times 10^{-1}$ | $3.29 \times 10^{-7}$ |
| 75 | 154.2 | $1.5 \times 10^{-1}$ | $3.72 \times 10^{-7}$ |
| 76 | 155.2 | $1.7 \times 10^{-1}$ | $4.25 \times 10^{-7}$ |
| 77 | 156.2 | $1.9 \times 10^{-1}$ | $4.81 \times 10^{-7}$ |
| 78 | 157.1 | $2.2 \times 10^{-1}$ | $5.44 \times 10^{-7}$ |
| 79 | 158.1 | $2.5 \times 10^{-1}$ | $6.16 \times 10^{-7}$ |
| 80 | 159.1 | $2.8 \times 10^{-1}$ | $6.97 \times 10^{-7}$ |

Table 3

| Measurement Number | Current Value $I_1$~$I_{115}$(A) | Voltage Value $V_{1,1}$~$V_{1,115}$(V) | Voltage Value per cm (V/cm) |
|---|---|---|---|
| 81 | 160.1 | $3.3 \times 10^{-1}$ | $8.15 \times 10^{-7}$ |
| 82 | 161.0 | $3.5 \times 10^{-1}$ | $8.80 \times 10^{-7}$ |
| 83 | 162.0 | $4.0 \times 10^{-1}$ | $9.92 \times 10^{-7}$ |
| 84 | 163.0 | $4.4 \times 10^{-1}$ | $1.11 \times 10^{-6}$ |
| 85 | 164.0 | $5.0 \times 10^{-1}$ | $1.24 \times 10^{-6}$ |
| 86 | 164.9 | $5.5 \times 10^{-1}$ | $1.39 \times 10^{-6}$ |
| 87 | 165.9 | $6.2 \times 10^{-1}$ | $1.54 \times 10^{-6}$ |

(continued)

| Measurement Number | Current Value $I_1$~$I_{115}$(A) | Voltage Value $V_{1,1}$~$V_{1,115}$(V) | Voltage Value per cm (V/cm) |
|---|---|---|---|
| 88 | 166.9 | $6.9 \times 10^{-1}$ | $1.72 \times 10^{-6}$ |
| 89 | 167.9 | $7.6 \times 10^{-1}$ | $1.91 \times 10^{-6}$ |
| 90 | 168.8 | $8.5 \times 10^{-1}$ | $2.12 \times 10^{-6}$ |
| 91 | 169.8 | $9.4 \times 10^{-1}$ | $2.35 \times 10^{-6}$ |
| 92 | 170.8 | 1.0 | $2.62 \times 10^{-6}$ |
| 93 | 171.7 | 1.1 | $2.87 \times 10^{-6}$ |
| 94 | 172.7 | 1.3 | $3.18 \times 10^{-6}$ |
| 95 | 173.7 | 1.4 | $3.50 \times 10^{-6}$ |
| 96 | 174.7 | 1.5 | $3.86 \times 10^{-6}$ |
| 97 | 175.6 | 1.7 | $4.25 \times 10^{-6}$ |
| 98 | 176.6 | 1.9 | $4.66 \times 10^{-6}$ |
| 99 | 177.6 | 2.0 | $5.11 \times 10^{-6}$ |
| 100 | 178.5 | 2.2 | $5.59 \times 10^{-6}$ |
| 101 | 179.5 | 2.4 | $6.12 \times 10^{-6}$ |
| 102 | 180.5 | 2.7 | $6.70 \times 10^{-6}$ |
| 103 | 181.5 | 2.9 | $7.31 \times 10^{-6}$ |
| 104 | 182.4 | 3.2 | $7.98 \times 10^{-6}$ |
| 105 | 183.4 | 3.5 | $8.71 \times 10^{-6}$ |
| 106 | 184.4 | 3.8 | $9.47 \times 10^{-6}$ |
| 107 | 185.3 | 4.1 | $1.03 \times 10^{-5}$ |
| 108 | 186.3 | 4.5 | $1.12 \times 10^{-5}$ |
| 109 | 187.3 | 4.9 | $1.22 \times 10^{-5}$ |
| 110 | 188.2 | 5.3 | $1.32 \times 10^{-5}$ |
| 111 | 189.2 | 5.7 | $1.43 \times 10^{-5}$ |
| 112 | 190.2 | 6.2 | $1.55 \times 10^{-5}$ |
| 113 | 191.2 | 6.7 | $1.67 \times 10^{-5}$ |
| 114 | 192.1 | 7.2 | $1.81 \times 10^{-5}$ |
| 115 | 193.1 | 7.8 | $1.96 \times 10^{-5}$ |

Referring to Tables I to 3 and Fig. 5, the voltage values are measured by increasing the set value of the constant current source by about 5 A at a time in measurement numbers 1 to 22 exhibiting current values not yet exceeding 100 A, while the voltage values are measured by increasing the set value of the constant current source by about 1 A at a time for measurement numbers 23 to 115 exhibiting current values exceeding 100 A, The rate of rise of the set value of the constant current source is reduced after the current value exceeds 100 A, in order to obtain a correct critical current value by obtaining a large number of data of current values around the critical current value. As shown in Fig. 5, proportionality holds between the logarithms of the voltage values and the current values.

Then, the critical current value of the first section is decided on the basis of the measured current values and voltage values. More specifically, the current value exceeding the critical voltage value (1 $\mu$V (= $1 \times 10^{-6}$ V)/cm, for example) for the first time is decided as the critical current value from among the set of the measured current values $I_1$ to $I_{115}$ and voltage values $V_1$ to $V_{115}$. Referring to Tables 1 to 3, the voltage value per cm exceeds 1 $\mu$V for the first time in the measurement number 84 (voltage value per cm: $111 \times 10^{-6}$ V/cm). Therefore, the current value 163.0 A of the measurement number 84 is regarded as the critical current value of the first section.

Then, electrode drive portion 31 moves upward, for separating upper current electrodes 14a and 14c and upper voltage electrodes 13a and 13c from superconducting wire 1. Then, superconducting wire 1 is taken up on backing roller 12 so that the second section (portion between the positions of 4 m and 8 m from the first end of superconducting wire 1) is located on the portion of measurement section 100. Thereafter the critical current value in the second section is measured by a method similar to that in the first section. The critical current values in all sections (first to $25^{th}$ sections) in superconducting wire 1 are measured by this method.

The method of measuring the critical current value of superconducting wire 1 according to this embodiment comprises the steps of dividing the total length of superconducting wire 1 into 25 constant lengths of the first to $25^{th}$ sections and measuring first to $115^{th}$ current values ($I_1, I_2, \cdots, I_{115}$) and first to $115^{th}$ voltage values ($V_{1,1}$ to $V_{115}, V_{2,1}$ to $V_{2,115}, \cdots, V_{25,1}$ to $V_{25,115}$) corresponding to the respective ones of the first to $115^{th}$ current values by feeding the current to the respective sections from the first section to the $25^{th}$ section and varying the value of the current. The first current value ($I_1$) and the first voltage value ($V_{1,1}, V_{2,1}, \cdots, V_{25,1}$) in each of the first section to the $25^{th}$ section are measured by retaining the current fed from constant current source 6 to superconducting wire 1 in the state set to the first set value $I_{1a}$ for a constant time and thereafter measuring the current flowing through superconducting wire 1 and the voltage generated in superconducting wire 1. The $j^{th}$ (j denotes an integer satisfying $2 \leq j \leq 115$) current value ($I_j$) and the $j^{th}$ voltage value ($V_{1j}, V_{2j}, \cdots, V_{25j}$) in each of the first section to the $25^{th}$ section are measured by retaining the current fed from constant current source 6 to superconducting wire 1 in a state set to the $j^{th}$ set value ($I_{ja}$) higher than the $(j-1)^{th}$ set value ($I_{(j-1)a}$) for the constant time and thereafter measuring the current flowing through superconducting wire 1 and the voltage generated in superconducting wire 1.

According to the method of measuring the critical current value of a superconducting wire in this embodiment, induced electromotive force resulting from the inductance of superconducting wire 1 can be reduced by retaining the current fed from constant current source 6 to superconducting wire 1 in the state set to the prescribed set value for the constant time. Therefore, the voltage value can be measured after the current flowing through superconducting wire 1 is stabilized, so that a correct critical current value can be obtained.

According to the method of measuring the critical current value of superconducting wire 1 in this embodiment, further, the critical current value along the total length or in a specific section can be measured as to a long superconducting wire having a length exceeding 100 m, for example.

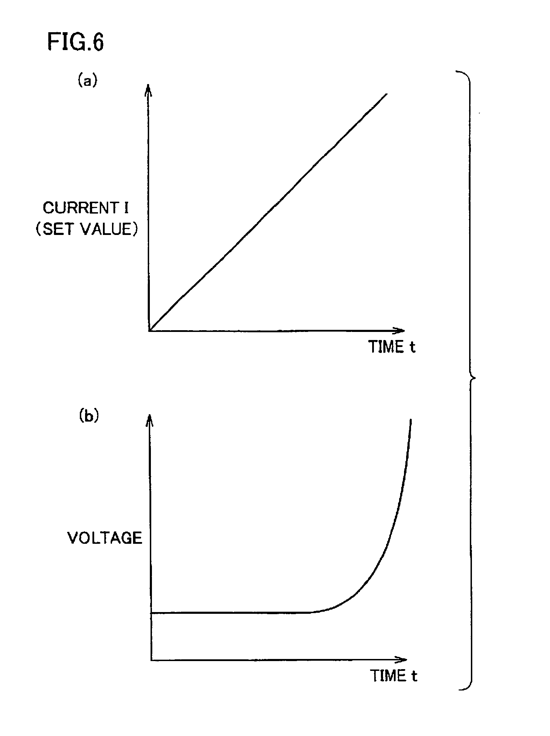

Fig. 6(a) is a diagram showing a time change in the set value of the constant current source in a case of increasing the set value of the constant current source in proportion to time, and Fig. 6(b) is a diagram showing a time change in the voltage generated in the superconducting wire in the case of increasing the set value of the constant current source in proportion to time. Referring to Figs. 6(a) and 6(b), the set value of the constant current source is not retained for a constant time when the set value of the constant current source is increased in proportion to time. Therefore, the voltage value is measured when induced electromotive force resulting from the inductance of the superconducting wire is large. Therefore, a voltage value smaller than the actual value is obtained, and no correct critical current value can be obtained.

The case of dividing a long superconducting wire into first to $25^{th}$ sections and measuring the critical current values in the respective sections has been shown in this embodiment. However, the measuring method according to the present invention is also applicable to measurement of the critical current in a short superconducting wire less than 100 m in length. In the case of measuring the critical current value of a short superconducting wire, the superconducting wire is not divided but the critical current value along the total length is measured at once. In other words, first to $m^{th}$ current values ($I_1, I_2, \cdots, I_m$) along the total length of the superconducting wire and first to $m^{th}$ voltage values ($V_1, V_2, \cdots, V_m$) corresponding to the respective ones of the first to $m^{th}$ current values are measured. Then, the critical current value is decided by a method similar to the above.

The method of measuring the critical current value of superconducting wire 1 in this embodiment is preferably carried out in an atmosphere of the room temperature with humidity of not more than 70 %. Thus, moisture contained in the atmosphere can be prevented from being introduced into cooling bath 7 along with superconducting wire 1. Consequently, fluctuation in the temperature (77.3 K) of liquid nitrogen 8 resulting from introduction of foreign matter such as ice can be suppressed. Further, no foreign matter such as ice is interposed between electrodes 13a to 13d and 14a to 14d and superconducting wire 1, whereby superconducting wire 1 can be prevented from flawing in measurement of the critical current value.

In addition, the rotational speed of feed roller 11 and backing roller 12 (feed rate for superconducting wire 1) is preferably at least 8 m/min. and not more than 20 m/min. A prescribed portion of superconducting wire 1 can be moved to measurement section 100 in a short time by setting the feed rate for superconducting wire 1 to at leas 8 m/min. Further, superconducting wire 1 present in the vicinity of backing roller 12 can be prevented from abrupt temperature rise by setting the feed rate for superconducting wire I to not more than 20 m/min. Superconducting wire I present in the vicinity of backing roller 12, just taken out from liquid nitrogen 8, is easily ballooned (swollen) due to abrupt temperature rise from the liquid nitrogen temperature to the room temperature. Such ballooning can be prevented by setting the feed rate for superconducting wire 1 to not more than 20 m/min.

(Second Embodiment)

In the method of measuring the critical current value according to the first embodiment, the voltage values are measured by increasing the set value of the constant current source by 5 A at a time until the current value exceeds 100 A, and the voltage values are measured by increasing the set value of the constant current source by 1 A at a time after the current value exceeds 100 A. From among the sets of the measured current values and voltage values, the current value exceeding the prescribed critical voltage value for the first time is decided as the critical current value.

In a method of measuring the critical current value according to this embodiment, on the other hand, voltage values are measured by increasing the set value of a constant current source at a constant rate (5 A, for example) regardless of the current value. Table 4 shows exemplary sets of current values $I_1$ to $I_{40}$ and voltage values $V_{1,1}$ to $V_{1,40}$ measured in a first section of a superconducting wire 1 in a case where a measurement frequency $\underline{m}$ is 40 times as exemplary measurement results obtained according to the measuring method of this embodiment. Fig. 7 shows the relation between the current values and the voltage values in Table 4.

Table 4

| Measurement Number | Current Value $I_1$~$I_{40}$(A) | Voltage Value $V_{1.1}$ ~$V_{1.40}$(V) | Voltage Value per cm (V/cm) |
|---|---|---|---|
| 1 | -0.2 | $-7.0 \times 10^{-5}$ | $-1.74 \times 10^{-10}$ |
| 2 | 4.6 | $7.4 \times 10^{-4}$ | $1.84 \times 10^{-9}$ |
| 3 | 9.5 | $2.0 \times 10^{-3}$ | $5.09 \times 10^{-9}$ |
| 4 | 14.4 | $2.6 \times 10^{-3}$ | $6.45 \times 10^{-9}$ |
| 5 | 19.3 | $9.4 \times 10^{-4}$ | $2.35 \times 10^{-9}$ |
| 6 | 24.2 | $-7.8 \times 10^{-4}$ | $-1.94 \times 10^{-9}$ |
| 7 | 29.1 | $3.0 \times 10^{-3}$ | $7.42 \times 10^{-9}$ |
| 8 | 34.0 | $-2.3 \times 10^{-3}$ | $-5.73 \times 10^{-9}$ |
| 9 | 38.9 | $2.2 \times 10^{-3}$ | $5.53 \times 10^{-9}$ |
| 10 | 43.8 | $-2.4 \times 10^{-3}$ | $-5.90 \times 10^{-9}$ |
| 11 | 48.7 | $-1.3 \times 10^{-3}$ | $-3.20 \times 10^{-9}$ |
| 12 | 53.6 | $-6.4 \times 10^{-5}$ | $-1.60 \times 10^{-10}$ |
| 13 | 58.5 | $1.0 \times 10^{-4}$ | $2.62 \times 10^{-10}$ |
| 14 | 63.4 | $-1.6 \times 10^{-4}$ | $-3.90 \times 10^{-10}$ |
| 15 | 68.3 | $2.1 \times 10^{-4}$ | $5.31 \times 10^{-10}$ |
| 16 | 73.1 | $1.5 \times 10^{-3}$ | $3.83 \times 10^{-9}$ |
| 17 | 78.0 | $-4.4 \times 10^{-4}$ | $-1.10 \times 10^{-9}$ |
| 18 | 82.9 | $5.9 \times 10^{-4}$ | $1.48 \times 10^{-9}$ |
| 19 | 87.8 | $8.6 \times 10^{-4}$ | $2.15 \times 10^{-9}$ |
| 20 | 92.7 | $8.4 \times 10^{-4}$ | $2.09 \times 10^{-9}$ |
| 21 | 97.6 | $1.6 \times 10^{-3}$ | $3.91 \times 10^{-9}$ |
| 22 | 102.5 | $3.5 \times 10^{-4}$ | $8.86 \times 10^{-10}$ |
| 23 | 107.4 | $4.6 \times 10^{4}$ | $1.15 \times 10^{-9}$ |
| 24 | 112.3 | $1.8 \times 10^{-3}$ | $4.38 \times 10^{-9}$ |
| 25 | 117.2 | $1.6 \times 10^{-3}$ | $4.08 \times 10^{-9}$ |
| 26 | 122.0 | $2.4 \times 10^{-3}$ | $5.89 \times 10^{-9}$ |
| 27 | 126.9 | $3.8 \times 10^{-3}$ | $9.47 \times 10^{-9}$ |
| 28 | 131.8 | $4.6 \times 10^{-3}$ | $1.15 \times 10^{-8}$ |

(continued)

| Measurement Number | Current Value $I_1\sim I_{40}$(A) | Voltage Value $V_{1.1}\sim V_{1.40}$(V) | Voltage Value per cm (V/cm) |
|---|---|---|---|
| 29 | 136.7 | $1.1 \times 10^{-2}$ | $2.65 \times 10^{-8}$ |
| 30 | 141.6 | $2.4 \times 10^{-2}$ | $5.94 \times 10^{-8}$ |
| 31 | 146.4 | $4.9 \times 10^{-2}$ | $1.23 \times 10^{-7}$ |
| 32 | 151.3 | $1.0 \times 10^{-1}$ | $2.52 \times 10^{-7}$ |
| 33 | 156.2 | $1.9 \times 10^{-1}$ | $4.81 \times 10^{-7}$ |
| 34 | 161.0 | $3.5 \times 10^{-1}$ | $8.80 \times 10^{-7}$ |
| 35 | 165.9 | $6.2 \times 10^{-1}$ | $1.54 \times 10^{-6}$ |
| 36 | 170.8 | 1.0 | $2.62 \times 10^{-6}$ |
| 37 | 175.6 | 1.7 | $4.25 \times 10^{-6}$ |
| 38 | 180.5 | 2.7 | $6.70 \times 10^{-6}$ |
| 39 | 185.3 | 4.1 | $1.03 \times 10^{-5}$ |
| 40 | 190.2 | 6.2 | $1.55 \times 10^{-5}$ |

Referring to Table 4 and Fig. 7, the voltage values are measured by increasing the set value of the constant current source by about 5 A at a time regardless of the current values in this embodiment, whereby the measurement frequency is remarkably reduced as compared with the measurement results of the first embodiment shown in Tables 1 to 3. Further, proportionality holds between the logarithms of the voltage values and the current values, as shown in Fig. 7.

Then, a straight line showing the relation between a current I flowing through the superconducting wire and a voltage V generated in the first section of the superconducting wire is calculated on the basis of the current values $I_1$ to $I_{40}$ and the voltage values $V_{1.1}$ to $V_{1.40}$. This straight line is preferably calculated by the least-squares method. When the straight line is calculated by the least squares method on the basis of the current values $I_1$ to $I_{40}$ and the voltage values $V_{1.1}$ to $V_{1.10}$ in Table 4, the straight line of the following equation (1) is obtained:

$$\text{Voltage V (V/cm)} = 3.630 \times 10^{-50} \times (\text{current I})^{19.63} \ \dots \ (1)$$

Then, the critical current value in the first section of the superconducting wire is obtained from the obtained straight line. If the critical current value is $1 \times 10^{-6}$ (V/cm), for example, $1 \times 10^{-6}$ is substituted for the voltage V of the above expression (1). Consequently, a more precise value 163.2 A is obtained as the critical current value of the first section.

Thereafter the critical current value in a second section is measured by a method similar to that in the first section. The critical current values of the respective ones of all sections (first to 25th sections) in superconducting wire 1 are measured by this method.

The method of measuring the critical current value of a superconducting wire according to this embodiment further comprises the steps of calculating the straight line showing the relation between the current flowing through the superconducting wire and the voltage generated in the superconducting wire on the basis of the first to 40th current values ($I_1$, $I_2$, ..., $I_{40}$) and the first to 40th voltage values ($V_1$, $V_2$, ..., $V_{40}$) and calculating the critical current value of the superconducting wire with the straight line.

Thus, when the first to 40th current values ($I_1$, $I_2$, ..., $I_{40}$) and the first to 40th voltage values ($V_1$, $V_2$, ..., $V_{40}$) are obtained, the critical current value can be calculated from these values on the basis of the obtained expression (1). Therefore, the critical current value can be measured without actually measuring the current value serving as the critical current value and the voltage value corresponding thereto, whereby the critical current value can be more easily measured as compared with the case of the first embodiment, and the measurement can be speeded up.

Further, the straight line is calculated by the least squares method, whereby the precision of the calculated straight line is improved even if the measured current values and voltage values include errors, so that measurement errors in the critical current value can be minimized.

The case of obtaining the critical current values of the respective ones of the first to 25th sections has been shown in this embodiment. However, the measuring method according to the present invention is also applicable to measurement of the critical current values in sections from $x^{th}$ to $y^{th}$ sections (x and y denote integers, and $1 \leq x \leq y \leq$ n) included in the first to $25^{th}$ sections.

In a case of measuring the critical current values of the second to $24^{th}$ sections included in the first to $25^{th}$ sections, for example, the sum ($V_{sum(1)} = V_{1,1} + V_{2,1} + ... + V_{24,1}$) of first voltage values measured in the respective sections from the second section to the $24^{th}$ section to the sum ($V_{sum(40)} = V_{2,40} + V_{3,40} + ... + V_{24,40}$) of $40^{th}$ voltage values are calculated from the measurement results shown in Table 4. Then, a straight line showing the relation between the current flowing through the superconducting wire and the voltage generated in the superconducting wire is calculated on the basis of the first to $40^{th}$ current values ($I_1, I_2, ..., I_{40}$) and the sum ($V_{sum(1)} = V_{1,1} + V_{2,1}^{+} ... + V_{24,1}$) of the first voltage values to the sum ($V_{sum(40)} = V_{2,40} + V_{3,40} + ... + V_{24,40}$) of the $40^{th}$ voltage values. The critical current value of the superconducting wire is calculated with this straight line.

When the first to $40^{th}$ current values ($I_1, I_2, ..., I_{40}$) and the first to $40^{th}$ voltage values ($V_1, V_2, ..., V_{40}$) are obtained in the sections (second to $24^{th}$ sections) for measuring the critical current values are obtained by this method, the critical current values of the sections can be calculated on the basis of the straight line obtained from these values. Therefore, the critical current value can be measured without actually measuring the current value serving as the critical current value and the voltage value corresponding thereto, whereby the critical current value can be easily measured.

While the case of setting the increasing ratio of the set value of the constant current source to 5 A has been shown in this embodiment, the increasing ratio for the set value of the constant current source is arbitrary, and preferably about 1/20 of the critical current value. Further, the frequency for measuring the current values and the voltage values is arbitrary, and the measuring method according to the present invention is applicable if at least two sets of current values and voltage values are obtained.

While the case of calculating the value of the current flowing through the superconducting wire from the voltages on both ends of the shunt resistor is described in each of the first and second embodiments, the set value of the current of the constant current source may be regarded as the value of the current flowing through the superconducting wire.

The embodiments disclosed this time are to be considered as illustrative and not restrictive in all points. The range of the present invention is shown not by the above description but by the scope of claim for patent, and it is intended that all modifications in the meaning and range equivalent to the scope of claim for patent are included.

INDUSTRIAL APPLICABILITY

The measuring method according to the present invention is suitable for measurement of the critical current of a long superconducting wire exceeding 100 m in length.

**Claims**

1. A method of measuring the critical current value of a superconducting wire, comprising the step of measuring first to $m^{th}$, m denotes an integer of at least 2, current values, $I_1, I_2, ..., I_m$, and first to $m^{th}$ voltage values, $V_1, V_2, ..., V_m$, corresponding to the respective ones of said first to $m^{th}$ current values by feeding a current to a superconducting wire (1) and varying the value of the current,

   **characterized in**

   retaining the current fed from a constant current source (6) to said superconducting wire (1) in a state set to a first set value for a constant time ($t_0$) until the current value reaches a substantially constant value and thereafter measuring the current flowing through said superconducting wire (1) and a voltage generated in said superconducting wire (1), said current flowing being represented by a $k^{th}$ current value, k denotes an integer satisfying $2 \leq k \leq m$, and said voltage generated being represented by a $k^{th}$ voltage value measured by retaining the current fed from the constant current source (6) to said superconducting wire in a state set to a $k^{th}$ set value higher than a $(k - 1)^{th}$ set value for the constant time (to) to reduce a noise caused by induced electromotive force resulting from an inductance of said superconducting wire having a length in the meter range .

2. The method of measuring the critical current value of a superconducting wire according to claim 1, further comprising the steps of calculating a straight line showing the relation between the current flowing through said superconducting wire (1) and the voltage generated in said superconducting wire (1) on the basis of said first to $m^{th}$ current values, $I_1, I_2, ..., I_m$, and said first to $m^{th}$ voltage values, $V_1, V_2, ..., V_m$, and calculating the critical current value of the superconducting wire (1) with said straight line.

3. The method of measuring the critical current value of a superconducting wire according to claim 2, calculating said straight line with the least-squares method in the step of calculating said straight line.

**4.** The method of measuring the critical current value of a superconducting wire according to claim 1, further comprising the step of dividing the total length of a superconducting wire (1) into n lengths from a first section to an $n^{th}$ section; wherein
said step of measuring is carried out at the respective sections from said first section to said $n^{th}$ section.

**5.** The method of measuring the critical current value of a superconducting wire according to claim 4, further comprising the steps of:

calculating the sum, $V_{sum(1)} = V_{x,1} + V_{x,+1,1} + ... + V_{y,1}$, of said first voltage values measured in the respective sections from said $x^{th}$ section to said $y^{th}$ section, x and y denote integers, and $1 \le x \le y \le n$, to the sum, $V_{sum}(m) = V_{x,m} + V_{x,+1,m} + ... + V_{y,m}$, of said $m^{th}$ voltage values, where $V_{k,i}$ denotes a voltage value corresponding to an $i^{th}$ current value in a $k^{th}$ section, k denotes an integer of 1 to n, i denotes an integer of 1 to m, corresponding to the respective ones of said first section to said $n^{th}$ section and varying the value of the current,
calculating a straight line showing the relation between the current flowing through said superconducting wire (1) and the voltage generated in said superconducting wire on the basis of said first to $m^{th}$ current values, $I_1$, $I_2$, ..., $I_m$, and the sum, $V_{sum(1)} = V_{x,1} + V_{x,+1,1} + ... + V_{y,1}$, of said first voltage values to the sum, $V_{sum(m)} = V_{x,m} + V_{x,+1,m} + \cdots + V_{y,m}$, of said $m^{th}$ voltage values and calculating the critical current value of said superconducting wire with said straight line.

**6.** The method of measuring the critical current value of a superconducting wire according to claim 5, calculating said straight line with the least-squares method in the step of calculating said straight line.

**7.** The method of measuring the critical current value of a superconducting wire according to claim 1, wherein the step of measuring is carried out in an atmosphere of the room temperature with a humidity of not more than 70%.

**Patentansprüche**

**1.** Verfahren zum Messen des kritischen Stromwertes eines supraleitenden Drahtes, umfassend den Schritt des Messens erster bis m-ter Stromwerte $I_1$, $I_2$, ..., $I_m$, wobei m eine ganze Zahl von wenigstens 2 darstellt, und erster bis m-ter Spannungswerte $V_1$, $V_2$, ..., $V_m$, die jeweils einem der ersten bis m-ten Stromwerte entsprechen, durch Zuführen eines Stroms zu einem supraleitenden Draht (1) und Variieren des Wertes des Stroms,
**gekennzeichnet durch**
Halten des von einer Konstantstromquelle (6) dem supraleitenden Draht (1) zugeführten Stroms in einem Zustand, in dem er auf einen ersten festen Wert gesetzt ist, für eine konstante Zeit ($t_0$) bis der Stromwert einen im wesentlichen konstanten Wert erreicht und anschließendes Messen des **durch** den supraleitenden Draht (1) fließenden Stroms und einer in dem supraleitenden Draht (1) erzeugten Spannung, wobei der fließende Strom von einem k-ten Stromwert repräsentiert wird, wobei k eine ganze Zahl bezeichnet, die $2 \le k \le m$ erfüllt, und wobei die erzeugte Spannung von einem k-ten Spannungswert repräsentiert wird, der gemessen wird **durch** Halten des von der Konstantstromquelle (6) dem supraleitenden Draht zugeführten Stroms in einem Zustand, der auf einen k-ten festen Wert gesetzt ist, der höher ist als ein (k-1)-ter fester Wert für die konstante Zeit ($t_0$), um ein **durch** induzierte elektromotorische Kraft hervorgerufenes Rauschen zu reduzieren, das aus einer Induktivität des supraleitenden Drahtes resultiert und eine Länge im Meterbereich hat.

**2.** Verfahren zum Messen des kritischen Stromwertes eines supraleitenden Drahtes nach Anspruch 1, ferner umfassend die Schritte des Berechnens einer geraden Linie, die die Beziehung zwischen dem durch den supraleitenden Draht (1) fließenden Strom und der in dem supraleitenden Draht erzeugten Spannung zeigt, auf Basis der ersten bis m-ten Stromwerte $I_1$, $I_2$, ..., $I_m$, und der m-ten Spannungswerte $V_1$, $V_2$, ..., $V_m$ und des Berechnens des kritischen Stromwertes des supraleitenden Drahtes mittels der geraden Linie.

**3.** Verfahren zum Messen des kritischen Stromwertes eines supraleitenden Drahtes nach Anspruch 2, welches in dem Schritt des Berechnens der geraden Linie die gerade Linie mittels des Verfahrens der kleinsten Quadrate berechnet.

**4.** Verfahren zum Messen des kritischen Stromwertes eines supraleitenden Drahtes nach Anspruch 1, ferner umfassend den Schritt des Teilens der gesamten Länge eines supraleitenden Drahtes (1) in n Längen von einem ersten Abschnitt bis zu einem n-ten Abschnitt, wobei
der Schritt des Messens an den entsprechenden Abschnitten von dem ersten Abschnitt bis zu dem n-ten Abschnitt ausgeführt wird.

**5.** Verfahren zum Messen des kritischen Stromwertes eines supraleitenden Drahtes nach Anspruch 4, ferner umfassend die Schritte des:

Berechnens der Summe $V_{sum(1)} = V_{x,1} + V_{x,+1,1} + ... + V_{y,1}$ der ersten Stromwerte, die in den entsprechenden Abschnitten von dem x-ten Abschnitt bis zum y-ten Abschnitt gemessen sind, wobei x und y ganze Zahlen darstellen und $1 \leq x \leq y \leq n$ gilt, bis zur Summe $V_{sum(m)} = V_{x,m} + V_{x,+1,m} + ... + V_{y,m}$ der m-ten Spannungswerte, wobei $V_{k,i}$ einen Spannungswert darstellt, der einem i-ten Stromwert in einem k-ten Abschnitt entspricht, wobei k eine ganze Zahl von 1 bis n darstellt, i eine ganze Zahl von 1 bis m darstellt, entsprechend einem jeweiligen des ersten Abschnitts bis n-ten Abschnitts, und Variierens des Wertes des Stroms,
Berechnens einer geraden Linie, die die Beziehung zwischen dem durch den supraleitenden Draht (1) fließenden Strom und der in dem supraleitenden Draht erzeugten Spannung darstellt, auf Basis der ersten bis m-ten Stromwerte $I_1$, $I_2$, ..., $I_m$ und der Summe $V_{sum(1)}$ $V_{x,1} + V_{x,+1,1} + ... + V_{y,1}$ der ersten Stromwerte zu der Summe $V_{sum(m)} = V_{x,m} + V_{x,+1,m} + ... + V_{y,m}$ der m-ten Spannungswerte, und Berechnens der kritischen Stromwerte des supraleitenden Drahtes mittels der geraden Linie.

**6.** Verfahren zum Messen des kritischen Stromwertes eines supraleitenden Drahtes nach Anspruch 5, welches in dem Schritt des Berechnens der geraden Linie die gerade Linie mittels des Verfahrens der kleinsten Quadrate berechnet.

**7.** Verfahren zum Messen des kritischen Stromwertes eines supraleitenden Drahtes nach Anspruch 1, wobei der Schritt des Messens in einer Atmosphäre bei Raumtemperatur mit einer Luftfeuchtigkeit von nicht mehr als 70% ausgeführt wird.

## Revendications

**1.** Procédé de mesure de la valeur du courant critique d'un fil supraconducteur comprenant l'étape consistant à mesurer une première à une m-ème, m représentant un entier supérieur ou égal à 2, valeurs de courant $I_1$, $I_2$, ..., $I_m$ et une première à une m-ème valeurs de tension $V_1$, $V_2$, ..., $V_m$, correspondant aux valeurs respectives desdites première à m-ème valeurs de courant en fournissant un courant à un fil supraconducteur (1) et en faisant varier la valeur du courant,
**caractérisé par**
maintenir le courant fourni par une source de courant constant (6) audit fil supraconducteur (1) dans un état fixé à une première valeur déterminée pendant un temps constant (to) jusqu'à ce que la valeur du courant atteigne une valeur sensiblement constante et après cela, mesurer le courant traversant ledit fil supraconducteur (1) et une tension générée dans ledit fil supraconducteur (1), ledit courant circulant étant représenté par une k-ème valeur de courant, k représentant un entier satisfaisant à $2 \leq k \leq m$ et ladite tension générée étant représentée par la k-ème valeur de tension mesurée en maintenant le courant fourni par la source de courant constant (6) audit fil supraconducteur dans un état fixé à une k-ème valeur déterminée supérieure à une (k-1)-ème valeur déterminée pendant le temps constant (to) pour diminuer le bruit provoqué par la force électromotrice induite résultant de l'inductance dudit fil supraconducteur dont la longueur est de l'ordre du mètre.

**2.** Procédé de mesure de la valeur du courant critique d'un fil supraconducteur selon la revendication 1, comprenant en outre les étapes consistant à calculer une ligne droite montrant la relation entre le courant traversant ledit fil supraconducteur (1) et la tension générée dans ledit fil supraconducteur (1) en se basant sur lesdites première à m-ème valeurs de courant $I_1$, $I_2$, ..., $I_m$ et lesdites première à m-ème valeurs de tension $V_1$, $V_2$, ..., $V_m$, et en calculant la valeur du courant critique du fil supraconducteur (1) avec ladite ligne droite.

**3.** Procédé de mesure de la valeur du courant critique d'un fil supraconducteur selon la revendication 2, en calculant ladite ligne droite avec la méthode des moindres carrés à l'étape de calcul de ladite ligne droite.

**4.** Procédé de mesure de la valeur du courant critique d'un fil supraconducteur selon la revendication 1, comprenant en outre l'étape consistant à diviser la longueur totale d'un fil supraconducteur (1) en n longueurs d'une première section jusqu'à une n-ème section; dans lequel
ladite étape de mesure est exécutée sur les sections respectives de ladite première section à ladite n-ème section.

**5.** Procédé de mesure de la valeur du courant critique d'un fil supraconducteur selon la revendication 4, comprenant en outre les étapes consistant à:

calculer la somme $V_{sum(1)} = V_{x,1} + V_{x,+1,1} + ... + V_{y,1}$, desdites premières valeurs de tension mesurées dans les sections respectives de ladite x-ème section à ladite y-ème section, x et y étant des entiers et $1 \leq x \leq y \leq n$, jusqu'à la somme, $V_{sum(m)} = V_{x,m} + V_{x,+1,m} + ... + V_{y,m}$, desdites m-èmes valeur de tension, où $V_{k,i}$ est une valeur de tension correspondant à la i-ème valeur de courant dans une k-ème section, k est un entier allant de 1 à n, i est un entier allant de 1 à m, correspondant aux sections respectives parmi la première section jusqu'à ladite n-ème section et faire varier la valeur du courant,

calculer une ligne droite montrant la relation entre le courant traversant ledit fil supraconducteur (1) et la tension générée dans ledit fil supraconducteur en se basant sur lesdites première à m-ème valeurs de courant, $I_1, I_2, ..., I_m$ et la somme, $V_{sum(1)} = V_{x,1} + V_{x,+1,1} + ... + V_{y,1}$, desdites premières valeurs de tension jusqu'à la somme, $V_{sum(m)} = V_{x,m} + V_{x,+1,m} + ... + V_{y,m}$, desdites m-ème valeurs de tension et calculer la valeur de courant critique dudit fil supraconducteur avec ladite ligne droite.

6. Procédé de mesure de la valeur du courant critique d'un fil supraconducteur selon la revendication 5, en calculant ladite ligne droite avec la méthode des moindres carrés à l'étape de calcul de ladite ligne droite.

7. Procédé de mesure de la valeur du courant critique d'un fil supraconducteur selon la revendication 1, dans lequel l'étape de mesure est exécutée dans une atmosphère à la température ambiante avec une humidité inférieure ou égale à 70 %.

FIG.1

FIG.2

## FIG.3

FIG.4A

CURRENT I
(SET VALUE)

I4a

I3a

I2a

I1a

t0

t1   t2 t3

TIME t

FIG.4B

ACTUAL VOLTAGE
(ACTUAL CURRENT I)

V4

V3

V2

V1

A

t0

t1   t2 t3

TIME t

FIG.4C

A

FIG.4D

## FIG.5

FIG.6

(a)

CURRENT I
(SET VALUE)

TIME t

(b)

VOLTAGE

TIME t

FIG.7

$$\text{VOLTAGE(V/cm)} = 3.630 \times 10^{-50} \times \text{CURRENT}^{19.63}(A)$$

FIG.8

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10239260 A